# EUROPÄISCHE PATENTANMELDUNG

(11) **EP 1 760 040 A2**
(43) Veröffentlichungstag der Anmeldung: **07.03.2007**
(21) Anmeldenummer: 06118785.2
(22) Anmeldetag: 11.08.2006
(51) Int. Cl.: B81C 5/00

(54) **Mikromechanisches Bauelement mit anodisch gebondeter Kappe und Herstellungsverfahren**

(30) Priorität: 29.08.2005 DE 102005040789
(71) Anmelder: ROBERT BOSCH GMBH, 70442 Stuttgart (DE)
(72) Erfinder: Stahl, Heiko, 72760, Reutlingen (DE); Ulbrich, Nicolaus, 72810, Gomaringen (DE); Straub, Rainer, 72119, Ammerbuch (DE)

(57) **Zusammenfassung**

Die Erfindung geht aus von einem mikromechanisches Bauelement mit einem Kappenwafer wenigstens bestehend aus einem ersten Siliziumsubstrat (1) und einem dünnen Glassubstrat (2), mit einem Funktionswafer wenigstens bestehend aus einem zweiten Siliziumsubstrat (5), wobei an dem Funktionswafer wenigstens eine elektrische Kontaktfläche (6) angeordnet ist. Der Kappenwafer ist an dem Glassubstrat (2) durch anodisches Bonden mit dem Funktionswafer verbunden. Der Kern der Erfindung besteht darin, dass die elektrische Kontaktfläche (6) an einer dem Kappenwafer zugewandten Seite des Funktionswafers angeordnet ist und der Kappenwafer wenigstens eine Ausnehmung aufweist, derart, dass zu der elektrischen Kontaktfläche (6) ein Zugang (9) gewährt ist. Die Erfindung betrifft weiterhin ein Verfahren zur Verkappung eines mikromechanischen Bauelements mit einem Kappenwafer durch anodisches Bonden des Kappenwafers auf einen Funktionswafer.

## Beschreibung

### STAND DER TECHNIK

Die Erfindung geht aus von einem mikromechanisches Bauelement mit einem Kappenwafer wenigstens bestehend aus einem ersten Siliziumsubstrat und einem dünnen Glassubstrat, mit einem Funktionswafer wenigstens bestehend aus einem zweiten Siliziumsubstrat, wobei an dem Funktionswafer wenigstens eine elektrische Kontaktfläche angeordnet ist. Der Kappenwafer ist an dem Glassubstrat durch anodisches Bonden mit dem Funktionswafer verbunden.

Die Erfindung betrifft weiterhin ein Verfahren zur Verkappung eines mikromechanischen Bauelements mit einem Kappenwafer durch anodisches Bonden des Kappenwafers auf einen Funktionswafer.

Die Erfindung betrifft ein Verfahren zur Strukturierung der Komposit-Kappe, das mit der elektrischen Kontaktierung bei der bisher üblichen Sealglas-Verkappungstechnologie kompatibel ist und bei dem auf die technologisch aufwendige Rückseiten-Kontaktierung verzichtet werden kann.

Inertialsensoren werden üblicherweise mit Kappenwafern aus Silizium durch Sealglas-Bonden verkappt. Eine solches Herstellungsverfahren ist in der deutschen Offenlegungsschrift DE 19700734 A1 offenbart. Die elektrische Kontaktierung erfolgt durch eigens zu diesem Zweck hergestellte Aussparungen im Kappenwafer. Eine dauerhaft hermetische und sichere Bondverbindung wird bei der Sealglas-Bondung nur mit relativ breiten Bondrahmen ermöglicht.

Durch die Verwendung von anodisch bondbaren Kappenwafern ist eine signifikante Reduktion der Bondrahmenbreite und damit des Flächenbedarfs pro Sensorchip möglich. Daher werden in neueren Verkappungstechniken wie z.B. der in der deutschen Offenlegungsschrift DE 10104868 A1 vorgestellten MPT (engl.: Micro Packaging Technology) anodisch bondbare Kappenwafer verwendet. Hier werden anodisch bondbare Komposit-Wafer bestehend aus einem Silizium-Trägersubstrat und einem hinreichend dünnen Glassubstrat als Kappenwafer verwendet. Das Glassubstrat muss so dünn gewählt werden, dass die Sägbarkeit des Kappenwafers mit den üblicherweise verwendeten Serienanlagen sichergestellt ist.

Aufgrund der schwer zu realisierenden Strukturierung der Komposit-Kappe werden z.B. bei MPT die elektrischen Zugänge von der Rückseite des Sensorsubstrats mit einigem technologischen Aufwand hergestellt. Hierzu gehört zunächst die von den bisherigen Serienprozessen stark abweichende interne Verdrahtung der Sensorstrukturen. Des weiteren erfordert die komplizierte Rückseiten-Kontaktierung eine Planarisierung der Komposit-Kappe, Kantenschleifen und Rückschleifen des Sensorsubstrats, Stressabbau des Sensorsubstrats, Si-DRIE (engl.: Deep Reactive Ion Etching) von Isolationsgräben und schließlich eine aufwendige Refill-Technik inklusive der Herstellung von Bondpads auf der Rückseite des Sensorsubstrats.

### VORTEILE DER ERFINDUNG

Die Erfindung geht aus von einem mikromechanisches Bauelement mit einem Kappenwafer wenigstens bestehend aus einem ersten Siliziumsubstrat und einem dünnen Glassubstrat, mit einem Funktionswafer wenigstens bestehend aus einem zweiten Siliziumsubstrat, wobei an dem Funktionswafer wenigstens eine elektrische Kontaktfläche angeordnet ist. Der Kappenwafer ist an dem Glassubstrat durch anodisches Bonden mit dem Funktionswafer verbunden. Der Kern der Erfindung besteht darin, dass die elektrische Kontaktfläche an einer dem Kappenwafer zugewandten Seite des Funktionswafers angeordnet ist und der Kappenwafer wenigstens eine Ausnehmung aufweist, derart, dass zu der elektrischen Kontaktfläche ein Zugang gewährt ist.

Vorteilhaft sind dabei eine zu verkappende mikro-elektro-mechanische Funktionsstruktur und damit elektrisch verbundene Kontaktflächen auf derselben Seite des Funktionswafers angeordnet, wodurch die elektrische Leitungsführung und somit der Aufbau des mikromechanischen Bauelements vereinfacht wird. Vorteilhaft ist weiterhin der geringe Platzbedarf für die Verbindung von Funktionswafer und Kappenwafer durch die anodische Bondverbindung.

Eine vorteilhafte Ausgestaltung des mikromechanischen Bauelements sieht vor, dass die Ausnehmung eine Zugangsöffnung im Kappenwafer in Form eines Kontaktlochs ist. Dies erlaubt es vorteilhaft die Kontaktflächen an nahezu beliebiger Stelle auf der dem Kappenwafer zugewandten Seite des Funktionswafers zu platzieren.

Die Erfindung betrifft weiterhin ein Verfahren zur Verkappung eines mikromechanischen Bauelements mit einem Kappenwafer durch anodisches Bonden des Kappenwafers auf einen Funktionswafer. Das erfindungsgemäße Verfahren umfasst die Herstellungsschritte:
(A) Bereitstellen eines Kappenwafer wenigstens bestehend aus einem ersten Siliziumsubstrat und einem dünnen Glassubstrat sowie eines Funktionswafers wenigstens bestehend aus einem zweiten Siliziumsubstrat mit wenigstens einer elektrischen Kontaktfläche.
(B) Schaffen von wenigstens einer ersten Ausnehmung in dem Kappenwafer.
(C) Anodisches Bonden des Kappenwafers auf der Seite des dünnen Glassubstrats an den Funktionswafer, wobei die erste Ausnehmung in dem Kappenwafer gegenüber der elektrischen Kontaktfläche des Funktionswafers angeordnet ist.
(D) Schaffen von wenigstens einer zweiten Ausnehmung in dem Kappenwafer, welche bis zur ersten Ausnehmung vorangetrieben wird, derart, dass zu der elektrischen Kontaktfläche ein Zugang geöffnet wird.

Vorteilhaft ist dabei, dass das erfindungsgemäße Verfahren zur Strukturierung des Kappenwafers in Form einer Komposit-Kappe mit der elektrischen Kontaktierung bei der bisher üblichen Sealglas-Verkappungstechnologie kompatibel ist und auf die technologisch aufwendige Rückseiten-Kontaktierung verzichtet werden kann.

Eine vorteilhafte Ausgestaltung des erfindungsgemäßen Verfahrens sieht vor, dass nach dem anodischen Bonden des Funktionswafers mit dem Kappenwafer, der Kappenwafer rückseitig abgedünnt wird. Vorteilhaft können hier Kosten für nachfolgende Prozeßschritte zur Schaffung eines Zugangs zur elektrischen Kontaktfläche gespart werden.

Eine weitere vorteilhafte Ausgestaltung des erfindungsgemäßen Verfahrens sieht vor, dass die zweite Ausnehmung in dem Kappenwafer derart vorangetrieben wird, dass zuerst das erste Siliziumsubstrat mittels eines SI-RIE Ätzprozesses strukturiert wird, danach das dünne Glassubstrat mittels eines naßchemischen Ätzverfahrens vorstrukturiert wird und schließlich mittels eines trockenchemischen Ätzverfahrens, wie beispielsweise Oxid-RIE (RIE - engl.: Reactive Ion Etching), die zweite Ausnehmung durch das dünne Glassubstrat hindurch bis zur ersten Ausnehmung vorangetrieben wird. Vorteilhaft dient dabei das strukturierte erste Siliziumsubstrat als Maske für die beiden nachfolgenden Schritte zur Strukturierung des Glassubstrats. Vorteilhaft, weil kostengünstig ist das nachfolgende Vorstrukturieren des Glassubstrats. Vorteilhaft ist schließlich auch das Strukturieren des Glassubstrats mittels eines trockenchemischen Ätzverfahrens bis zur Öffnung eines Zugangs zur Kontaktfläche weil mit diesem Prozeßschritt die Kontaktfläche nicht angegriffen wird.

Das erfindungsgemäße Verfahren dient zur Verkappung von Inertialsensoren mit anodisch bondbaren Kappenwafern ohne die technisch aufwendige Rückseiten-Kontaktierung. Bei dem beschriebenen Verfahren wird der anodisch bondbare Kappenwafer in einer Weise strukturiert, die eine elektrische Kontaktierung der Sensorstrukturen wie bei der bisher üblichen Selaglas-Verkappungstechnik erlaubt.

Vorteilhaft ist dabei ein Verfahren zur Strukturierung eines anodisch bondbaren Komposit-Kappenwafers gezeigt, das eine elektrische Kontaktierung der unter dem Kappenwafer befmdlichen Sensorstrukturen ermöglicht. Das beschriebene Verfahren ermöglicht eine signifikante Flächenreduktion der Sensorchips gegenüber den bisherigen Sealglas-Verkappungstechniken und hält den technologischen Aufwand insbesondere im Vergleich zu Verfahren, die eine Rückseitenkontaktierung beinhalten gering. Daher stellt es eine vergleichsweise kostengünstige Alternative zur Verkappung von Inertialsensoren und sonstigen mikromechanischen Sensoren durch anodische Bondverfahren dar. Der mögliche Kostenvorteil gegenüber einer Rückseitenkontaktierung liegt in der Vermeidung bzw. dem Ersetzen einiger aufwendiger Prozessschritte. Besonders vorteilhaft ist dabei, dass das Planarisieren der Kappe entfallen kann, indem es nahezu kostenneutral durch ein Rückdünnen der Kappe ersetzt wird. Vorteilhaft entfallen bei dem erfindungsgemäßen Verfahren insbesondere das Rückschleifen und der Stressabbau des Sensorsubstrats, Si-DRIE von Isolationsgräben, die Refill-Technik und das Herstellen von elektrischen Kontaktflächen auf der Rückseite des Sensorsubstrats.

Ein weiterer Vorteil liegt in der Kompatibilität der bei diesem Verfahren erforderlichen Prozess-Plattform mit den bisherigen Prozessen und Anlagen der Serienproduktion mikromechanischer Erzeugnisse, da bei diesem Verfahren keine technisch aufwendige Rückseitenkontaktierung erforderlich ist.

Weiterhin ermöglicht das beschriebene Verfahren vorteilhaft eine Verkappung von Inertialsensoren mit dünnen Kappen. Die Begrenzung der Dicke nach unten ist durch die minimale Dicke des Glaswafers und die mechanische Stabilität der Kappe bestimmt. Erstere wird durch die Durchbruchspannung des Glassubstrats beim anodischen Bonden bestimmt. Zudem besteht die Möglichkeit auch den Funktionswafer rückseitig abzudünnen und so dünne Substrate, die auch für sogenannte "stacked chip" - Varianten geeignet sind, herzustellen.

Vorteilhaft kann die Erfindung bei Beschleunigungssensoren, Drehratensensoren und allen anderen mikromechanischen Sensoren, bei welchen eine Verkappung mit anodisch bondbaren Kappenwafern vorteilhaft ist, zum Einsatz kommen.

Weitere vorteilhafte Ausgestaltungen sind den Unteransprüchen zu entnehmen.

### ZEICHNUNG

Ausführungsbeispiele der Erfindung sind in der Zeichnung dargestellt und in der nachfolgenden Beschreibung näher erläutert.
Fig. 1 zeigt einen Kappenwafer in Form eines Komposit-Kappenwafers.
Fig. 2 zeigt das Einbringen von Ausnehmungen in den Kappenwafer.
Fig. 3 zeigt das anodische Bonden des Kappenwafers auf einen Funktionswafer.
Fig. 4 zeigt das rückseitige Abdünnen des Kappenwafers.
Fig. 5: zeigt einen ersten Teilschritt zur Schaffung einer zweiten Ausnehmung in dem Kappenwafer.
Fig. 6: zeigt einen zweiten Teilschritt zur Schaffung einer zweiten Ausnehmung in dem Kappenwafer.
Fig. 7: zeigt einen dritten Teilschritt zur Schaffung einer zweiten Ausnehmung in dem Kappenwafer und schematisch das erfindungsgemäße mikromechanische Bauelement.
Fig. 8 zeigt schematisch ein erfindungsgemäßes Verfahren zur Herstellung eines mikromechanischen Bauelements mit anodisch gebondeter Kappe.

### BESCHREIBUNG VON AUSFÜHRUNGSBEISPIELEN

Anhand der im Folgenden beschriebenen Ausführungsformen soll die Erfindung detailliert dargestellt werden.

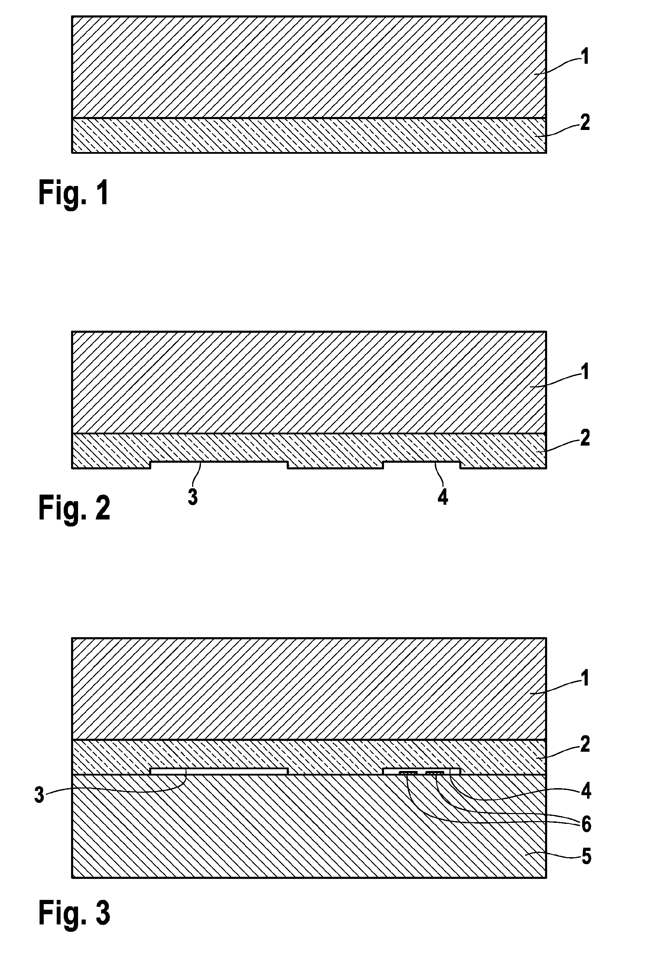

Fig. 1 zeigt einen Kappenwafer in Form eines Komposit-Kappenwafers bestehend aus einem ersten Siliziumsubstrat 1 und einem dünnen Glassubstrat 2. Das dünne Glassubstrat 2 soll die anodische Bondbarkeit des Kappenwafers ermöglichen.

Fig. 2 zeigt eine erste Ausnehmung 4 und eine weitere Ausnehmung 3 welche in das dünne Glassubstrat 2 des Kappenwafers eingebracht werden.

Fig. 3 zeigt das anodische Bonden des Komposit-Kappenwafers bestehend aus dem ersten Siliziumsubstrat 1 und dem dünnen Glassubstrat 2 auf einen Funktionswafer. Der Funktionswafer besteht wenigstens aus einem zweiten Siliziumsubstrat 5 und weist mindestens eine elektrische Kontaktfläche 6 sowie an derselben Seite eine mikromechanische Struktur auf, welche nicht gesondert dargestellt ist. Nach dem Bonden bildet die erste Ausnehmung 4 eine Kaverne über der elektrischen Kontaktfläche 6. Die weitere Ausnehmung 3 bildet eine Kaverne über der mikromechanischen Struktur und schützt diese Struktur durch Verkappung.

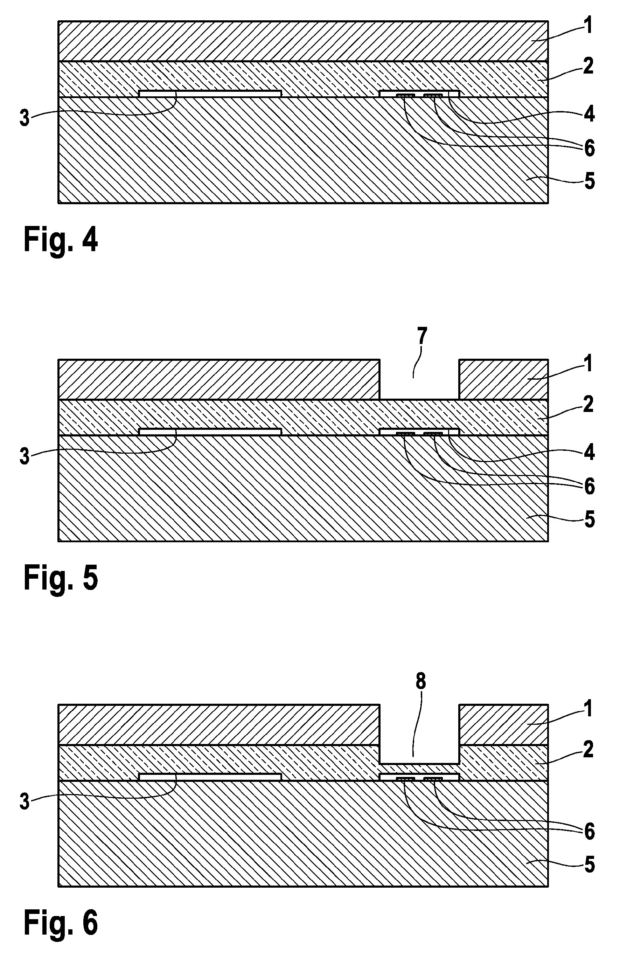

Fig. 4 zeigt das rückseitige Abdünnen des ersten Siliziumsubstrats 1 des Kappenwafers. Dieser Prozessschritt ist nicht zwingend erforderlich kann jedoch zu einer Reduktion der Prozesskosten beim folgenden Prozessschritt führen. Das Abdünnen kann durch übliche Verfahren, wie beispielsweise Schleifen oder Naßätzen erfolgen.

Fig. 5: zeigt einen ersten Teilschritt zur Schaffung einer zweiten Ausnehmung in dem Kappenwafer. Dazu wird oberhalb der ersten Ausnehmung 4 wenigstens eine erst Öffnung 7 in das erste Siliziumsubstrat 1 durch einen Si-RIE Prozess hineinstrukturiert. Prozessdauer und Prozesskosten hängen hierbei von der Restdicke des ersten Siliziumsubstrats 1 ab. Diese können durch den fakultativen, unter Fig. 4 beschriebenen, Prozeßschritt beeinflusst werden.

Fig. 6: zeigt einen zweiten Teilschritt zur Schaffung einer zweiten Ausnehmung in dem Kappenwafer. Nach der Schaffung der ersten Öffnung 7 stellt das erste Siliziumsubstrat 1 eine Maske dar, durch welche hindurch eine zweite Öffnung 8 in das Glassubstrat 2 hineinstrukturiert wird. Die Funktion des ersten Siliziumsubstrats 1 als Maske stellt ein wesentliches Merkmal bei diesem Prozessschritt dar. Dieser Prozessschritt ist nicht zwingend erforderlich, kann aber zu einer erheblichen Kostenreduktion beim nachfolgenden Prozessschritt führen. Die Vorstrukturierung kann im Batch-Prozess mit nasschemischen Ätzverfahren erfolgen und ist daher kostengünstig. Die zweite Öffnung 8 reicht noch nicht bis zur ersten Ausnehmung 4. Eine vollständige Strukturierung des Glassubstrats ist nämlich nicht ohne einen Schutz der elektrischen Kontaktflächen 6, in diesem Beispiel Aluminium-Bondpads, möglich, da die Aluminium-Oberfläche im Ätzbad fluoriert würde.

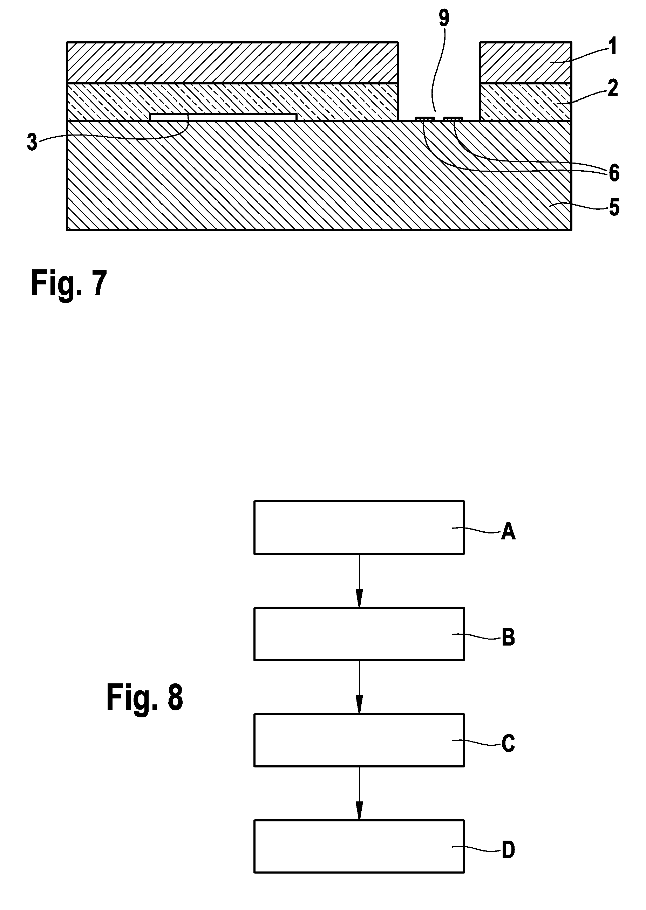

Fig. 7: zeigt einen dritten Teilschritt zur Schaffung einer zweiten Ausnehmung in dem Kappenwafer und schematisch das erfindungsgemäße mikromechanische Bauelement. Dazu wird in diesem Beispiel eine dritte Öffnung 9 in das Glassubstrat 2 mit trockenchemischen Ätzverfahren wie beispielsweise Oxid-RIE hineinstrukturiert. Ein wesentliches Merkmal bei diesem Prozessschritt ist wiederum die Funktion des im ersten Teilschritt vorstrukturierten ersten Siliziumsubstrats 1 als Maske beim Strukturieren des Glassubstrats 2 mit einer hohen Selektivität von Silizium gegenüber Glas von etwa 27:1. Durch den dritten Teilschritt wird letztlich durch den Kappenwafer hindurch ein Zugang 9 zu der elektrischen Kontaktfläche 6 geschaffen.

Fig. 8 zeigt schematisch ein erfindungsgemäßes Verfahren zur Herstellung eines mikromechanischen Bauelements mit anodisch gebondeter Kappe. Das erfindungsgemäße Verfahren umfasst die Herstellungsschritte:
(A) Bereitstellen eines Kappenwafer wenigstens bestehend aus einem ersten Siliziumsubstrat 1 und einem dünnen Glassubstrat 2 sowie eines Funktionswafers wenigstens bestehend aus einem zweiten Siliziumsubstrat 5 mit wenigstens einer elektrischen Kontaktfläche 6.
(B) Schaffen von wenigstens einer ersten Ausnehmung 4 in dem Kappenwafer.
(C) Anodisches Bonden des Kappenwafers auf der Seite des dünnen Glassubstrats 2 an den Funktionswafer, wobei die erste Ausnehmung 4 in dem Kappenwafer gegenüber der elektrischen Kontaktfläche 6 des Funktionswafers angeordnet ist.
(D) Schaffen von wenigstens einer zweiten Ausnehmung in dem Kappenwafer, welche bis zur ersten Ausnehmung 4 vorangetrieben wird, derart, dass zu der elektrischen Kontaktfläche 6 ein Zugang 9 geöffnet wird.

Es sind daneben auch weitere Ausführungsbeispiele denkbar.

## Patentansprüche

1. Mikromechanisches Bauelement
- mit einem Kappenwafer wenigstens bestehend aus einem ersten Siliziumsubstrat (1) und einem dünnen Glassubstrat (2)
- mit einem Funktionswafer wenigstens bestehend aus einem zweiten Siliziumsubstrat (5),
- wobei an dem Funktionswafer wenigstens eine elektrische Kontaktfläche (6) angeordnet ist,
- wobei der Kappenwafer an dem Glassubstrat (2) durch anodisches Bonden mit dem Funktionswafer verbunden ist,
**dadurch gekennzeichnet, dass**
- die elektrische Kontaktfläche (6) an einer dem Kappenwafer zugewandten Seite des Funktionswafers angeordnet ist und
- der Kappenwafer wenigstens eine Ausnehmung aufweist, derart, dass zu der elektrischen Kontaktfläche (6) ein Zugang (9) gewährt ist.

2. Mikromechanisches Bauelement nach Anspruch 1, **dadurch gekennzeichnet, dass** die Ausnehmung eine Zugangsöffnung im Kappenwafer in Form eines Kontaktlochs (9) ist.

3. Verfahren zur Herstellung eines mikromechanischen Bauelements mit den Herstellungsschritten:
(A) Bereitstellen eines Kappenwafer wenigstens bestehend aus einem ersten Siliziumsubstrat (1) und einem dünnen Glassubstrat (2) sowie eines Funktionswafers wenigstens bestehend aus einem zweiten Siliziumsubstrat (5) mit wenigstens einer elektrischen Kontaktfläche (6).
(B) Schaffen von wenigstens einer ersten Ausnehmung (4) in dem Kappenwafer.
(C) Anodisches Bonden des Kappenwafers auf der Seite des dünnen Glassubstrats (2) an den Funktionswafer, wobei die erste Ausnehmung (4) in dem Kappenwafer gegenüber der elektrischen Kontaktfläche (6) des Funktionswafers angeordnet ist.
(D) Schaffen von wenigstens einer zweiten Ausnehmung in dem Kappenwafer, welche bis zur ersten Ausnehmung (4) vorangetrieben wird, derart, dass zu der elektrischen Kontaktfläche ein Zugang (9) geöffnet wird.

4. Verfahren zur Herstellung eines mikromechanischen Bauelements nach Anspruch 3, **dadurch gekennzeichnet, dass** nach dem Herstellungsschritt (C) der Kappenwafer rückseitig abgedünnt wird.

5. Verfahren zur Herstellung eines mikromechanischen Bauelements nach einem der Ansprüche 3 oder 4, **dadurch gekennzeichnet, dass** im Herstellungsschritt (D) die zweite Ausnehmung in dem Kappenwafer derart vorangetrieben wird, dass
- zuerst das erste Siliziumsubstrat (1) mittels eines SI-RIE Ätzprozesses strukturiert wird,
- danach das dünne Glassubstrat (2) mittels eines naßchemischen Ätzverfahrens vorstrukturiert wird,
- und schließlich mittels eines trockenchemischen Ätzverfahrens, insbesondere Oxid-RIE, die zweite Ausnehmung durch das dünne Glassubstrat (2) hindurch bis zur ersten Ausnehmung (4) vorangetrieben wird.
